# FASCICULE DE BREVET EUROPEEN

(11) **EP 3 394 624 B1**
(45) Date de publication et mention de la délivrance du brevet: **20.05.2020**
(21) Numéro de dépôt: 16815626.3
(22) Date de dépôt: 07.12.2016
(51) Int. Cl.: G01R 31/00, H04L 12/40

(54) **DISPOSITIF DE TEST D'UNE PARTIE AU MOINS DE LA COUCHE PHYSIQUE D'UN RÉSEAU DE COMMUNICATION FILAIRE À HAUT DÉBIT**
VORRICHTUNG ZUM PRÜFEN MINDESTENS EINES TEILS DER PHYSIKALISCHEN SCHICHT EINES VERDRAHTETEN HOCHGESCHWINDIGKEITSKOMMUNIKATIONSNETZWERKS
DEVICE FOR TESTING AT LEAST PART OF THE PHYSICAL LAYER OF A HIGH-SPEED WIRED COMMUNICATION NETWORK

(30) Priorité: 21.12.2015 FR 1562924
(43) Date de publication de la demande: 31.10.2018
(73) Titulaire: PSA AUTOMOBILES S.A., 78300 Poissy (FR)
(72) Inventeur: MORAND, Nicolas, 92400 Courbevoie (FR)
(74) Mandataire: Jeannin, Laurent Jean-Pierre
(86) Numéro de dépôt international: PCT/FR2016/053250
(87) Numéro de publication internationale: WO 2017/109320

(56) Documents cités:
- EP-A2- 0 793 111
- US-A- 5 124 990

## Description

L'invention concerne les réseaux de communication filaires à haut débit et dits à communication bidirectionnelle sur un même médium, et plus précisément le test de tels réseaux.

On entend ici par « haut débit » un débit supérieur ou égal à environ 100 Mbits/s.

Dans les réseaux de communication du type précité chaque organe comporte au moins une interface de communication connectée à un médium de communication filaire, comme par exemple un fil électrique ou une fibre optique. Dans certains réseaux à communication dite « point à point », comme par exemple ceux de type Ethernet, chaque organe est connecté à au moins un autre organe via un médium de communication, et certains au moins des organes comprennent des moyens de routage chargés de router des messages reçus vers des organes destinataires. Par conséquent, chaque médium de communication ne relie entre eux que deux organes. Dans d'autres réseaux, comme par exemple ceux de type CAN (« Controller Area Network ») ou LIN (« Local Area Network »), chaque organe est connecté à un médium de communication commun (ou bus) via son interface de communication.

Comme le sait l'homme de l'art, dans les réseaux de communication filaires à haut débit, et en particulier ceux dits à communication bidirectionnelle sur un même médium, il s'avère difficile, voire impossible, de tester facilement la couche physique (couche 1 dans le modèle OSI), notamment lorsque les organes sont difficiles d'accès, comme c'est par exemple le cas dans des véhicules. Il est surtout difficile, voire impossible, de déterminer si chaque canal de communication assure le rôle qui lui a été attribué.

On entend ici par « canal de communication » un ensemble d'éléments physiques assurant la transmission filaire entre des premier et second organes, ces éléments étant une partie au moins de l'interface de communication du premier organe, au moins un médium de communication filaire, et une partie au moins de l'interface de communication du second organe.

En effet, le paramétrage d'une interface de communication peut être mal adapté, ou bien un médium de communication filaire peut être inadapté au débit réel des organes qu'il interconnecte ou dégradé. De plus, ces difficultés augmentent avec la vitesse de fonctionnement du réseau.

Par ailleurs, les équipements d'analyse existants (oscilloscopes et analyseurs de réseaux vectoriels) ne permettent pas l'analyse des signaux dans les réseaux à haut débit pour des raisons pratiques (inadaptation ou difficulté de mise en œuvre, par exemple dans un véhicule) et fonctionnelles (par exemple utilisation d'un « cryptage » au niveau de la couche physique et communication bidirectionnelle sur un même et unique médium compliquant fortement la mesure indépendante des signaux dans chaque sens de communication).

Certes, il a été récemment proposé d'équiper certains organes de moyens de test, mais ceux-ci ne peuvent que très partiellement tester la couche physique d'un réseau de communication filaire. Par exemple, ils ne peuvent que tester la conformité des signaux analogiques au niveau des interfaces de communication des organes.

On connait par le document EP 0 793 111 un système pour diagnostiquer les défauts de fonctionnement des unités de commande embarquées d'un véhicule (ou ECU) comprenant une pluralité d'ECU et un testeur de diagnostic. Les ECU sont connectées entre elles, formant un réseau de communication. Les ECU stockent des données relatives aux dysfonctionnements.

L'invention a donc notamment pour but d'améliorer la situation.

Elle propose notamment à cet effet un dispositif de test destiné à équiper un premier organe comprenant au moins une interface de communication propre à être connectée à un premier médium de communication filaire au sein d'un réseau de communication de type filaire, à haut débit, dit à communication bidirectionnelle sur un même médium, et comprenant au moins un second organe comportant au moins une interface de communication couplée au premier médium de communication (directement ou indirectement via un second médium de communication filaire et un médium de communication commun et filaire).

Ce dispositif se caractérise par le fait qu'il comprend des moyens de génération propres à être connectés à l'interface de communication de leur premier organe et/ou au premier médium de communication, et agencés pour générer un test destiné à être transmis à l'interface de communication de leur premier organe ou par le premier médium de communication pour provoquer une réaction à ce test d'une partie au moins de l'interface de communication du premier organe et d'au moins le premier médium de communication, et/ou d'une partie au moins de l'interface de communication du second organe.

Grâce à l'invention, on peut désormais tester certains au moins des canaux de communication de la couche physique d'un réseau de communication filaire, à haut débit et à communication bidirectionnelle sur un même médium. On entend ici par « canal de communication » un ensemble d'éléments physiques assurant la transmission filaire entre des premier et second organes, ces éléments étant une partie au moins de l'interface de communication du premier organe, au moins un médium de communication filaire, et une partie au moins de l'interface de communication du second organe.

Le dispositif selon l'invention peut comporter d'autres caractéristiques qui peuvent être prises séparément ou en combinaison, et notamment :
- ses moyens de génération peuvent être agencés pour générer un fichier de paramétrage définissant le test et propre à provoquer un nouveau paramétrage de l'interface de communication du premier organe et/ou de l'interface de communication du second organe ;
- en variante ou en complément, ses moyens de génération peuvent être agencés pour générer une forme d'onde (par exemple en tension) définissant le test et propre à être transmise par le premier médium de communication ;
- il peut comprendre des moyens de détermination agencés pour déterminer la réaction provoquée par le test, via le premier médium de communication et/ou l'interface de communication du premier organe ;
   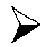 les moyens de détermination peuvent être agencés pour déterminer une variation de la forme d'onde résultant de la transmission de cette dernière depuis les moyens de génération, cette variation constituant la réaction ;
   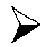 il peut comprendre des moyens d'enregistrement agencés pour enregistrer la réaction déterminée en correspondance d'un identifiant du test ;
- il peut comprendre des moyens de détermination agencés pour déterminer la réaction provoquée par le test, via les média de communication et l'interface de communication du second organe ;
- il peut comprendre une ligne de diagnostic propre à être couplée à un équipement de communication externe afin de transmettre aux moyens de génération une commande requérant la génération d'un test choisi ou une définition d'un test à générer et/ou de recevoir des résultats de test(s).

L'invention propose également un organe comprenant, d'une part, au moins une interface de communication propre à être connectée à un premier médium de communication au sein d'un réseau de communication de type filaire, à haut débit, dit à communication bidirectionnelle sur un même médium, et comprenant au moins un second organe comportant au moins une interface de communication connectée au premier médium de communication ou à un second médium de communication couplé au premier médium de communication via un médium de communication commun, et, d'autre part, au moins un dispositif de test du type de celui présenté ci-avant, et connecté à l'interface de communication et/ou à son premier médium de communication.

L'invention propose également un réseau de communication de type filaire, à haut débit, dit à communication bidirectionnelle sur un même médium, et comprenant au moins deux organes du type de celui présenté ci-avant et couplés entre eux via un médium de communication ou via au moins deux médiums de communication interconnectés via un médium de communication commun.

A titre d'exemple, un tel réseau de communication peut être de type Ethernet.

L'invention propose également un véhicule, éventuellement de type automobile, et comprenant au moins un réseau de communication du type de celui présenté ci-avant.

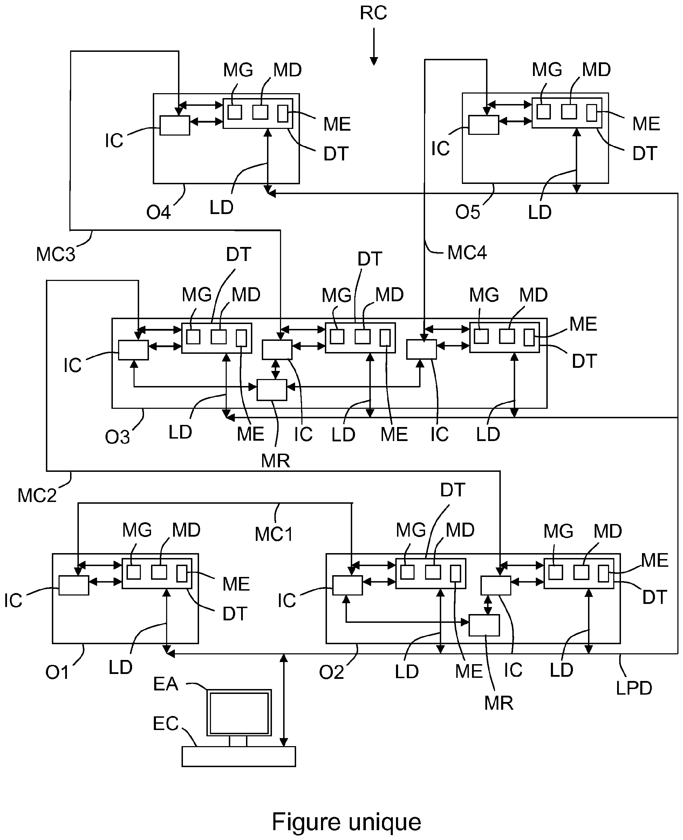

D'autres caractéristiques et avantages de l'invention apparaîtront à l'examen de la description détaillée ci-après, et du dessin annexé, sur lequel l'unique figure illustre schématiquement et fonctionnellement un exemple de réseau de communication filaire, à haut débit, à communication bidirectionnelle sur un même médium, et comprenant cinq organes équipés chacun d'au moins un exemple de réalisation d'un dispositif de test selon l'invention.

L'invention a notamment pour but de proposer un dispositif de test DT propre à équiper un organe Oj faisant partie d'un réseau de communication RC de type filaire, à haut débit, et à communication bidirectionnelle sur un même médium, et donc comprenant une couche physique (couche 1 du modèle OSI).

Dans ce qui suit, on considère, à titre d'exemple non limitatif, que le réseau de communication RC est de type dit « point à point ». Il s'agit par exemple d'un réseau Ethernet. Mais l'invention n'est pas limitée à ce type de réseau de communication filaire. D'une manière générale, l'invention concerne tout réseau de communication filaire à haut débit, à communication bidirectionnelle sur un même médium, et adapté à la transmission bidirectionnelle de données à haut débit entre organes comprenant chacun au moins une interface de communication connectée à un médium de communication filaire, comme par exemple un fil électrique ou une fibre optique. Par conséquent, l'invention concerne également les réseaux à haut débit, à communication bidirectionnelle sur un même médium, et comprenant au moins un médium de communication commun (ou bus) auquel sont connectés des média de communication qui sont par ailleurs connectés chacun à une interface de communication d'un organe, tels que l'Ethernet 10BASE-T à 10 Mbits/s ou le Flex-Ray, par exemple.

Par ailleurs, on considère dans ce qui suit, à titre d'exemple non limitatif, que le réseau de communication RC (filaire) est destiné à être installé dans un véhicule automobile, comme par exemple une voiture. Mais l'invention n'est pas limitée à cette application. Elle concerne en effet tout système, appareil, installation ou bâtiment pouvant comprendre au moins un réseau de communication filaire (et donc à couche physique) adapté à la transmission bidirectionnelle de données entre organes. Elle concerne donc notamment les véhicules, qu'ils soient de type terrestre, maritime (ou fluvial), ou aérien, les installations, éventuellement de type industriel ou domestique, et les bâtiments.

On a schématiquement représenté sur l'unique figure un exemple non limitatif de réseau (de communication) RC filaire, et, ici, de type point à point. Dans cet exemple, le réseau RC (de type Ethernet) comprend cinq organes Oj (j = 1 à 5). Mais le nombre d'organes Oj peut prendre n'importe quelle valeur supérieure ou égale à deux.

Chaque organe Oj comprend au moins une interface de communication IC connectée à un médium de communication MCk de type filaire. Dans l'exemple illustré non limitativement sur l'unique figure :
- l'organe O1 (j = 1) comprend une seule interface de communication IC connectée à un premier médium de communication MC1 (k = 1),
- l'organe 02 (j = 2) comprend deux interfaces de communication IC connectées respectivement au premier médium de communication MC1 et à un deuxième médium de communication MC2 (k = 2). Ce deuxième organe 02 (j = 2) comprend également un moyen de routage MR relié à ses deux interfaces de communication IC et chargé de router les données qu'il reçoit vers un organe Oj' (j' ≠ 2),
- l'organe 03 (j = 3) comprend trois interfaces de communication IC connectées respectivement au deuxième médium de communication MC2 et à des troisième MC3 (k = 3) et quatrième MC4 (k = 4) médiums de communication. Ce troisième organe 03 (j = 3) comprend également un moyen de routage MR relié à ses trois interfaces de communication IC et chargé de router les données qu'il reçoit vers un organe Oj' (j' ≠ 3),
- l'organe 04 (j = 4) comprend une seule interface de communication IC connectée au troisième médium de communication MC3, et
- l'organe 05 (j = 5) comprend une seule interface de communication IC connectée au quatrième médium de communication MC4.

Par exemple, chaque organe Oj peut être un calculateur communiquant ou une passerelle.

On notera que dans une variante de réseau de type point à point, tous les organes Oj pourraient tous être connectés en série, deux à deux. De plus, certains organes Oj pourraient ne pas comporter de moyen de routage.

On notera également que lorsque le réseau comprend un médium de communication commun (ou bus), chaque organe est connecté à ce bus via le médium de communication qui est connecté à son interface de communication. Par conséquent, aucun organe Oj n'a besoin de moyen de routage.

Comme illustré sur l'unique figure, au moins un organe Oj du réseau RC est équipé en interne d'au moins un dispositif de test DT.

Un dispositif de test DT, selon l'invention, comprend au moins des moyens de génération MG propres à être connectés à une interface de communication IC de l'organe Oj dont il fait partie et/ou à un médium de communication MCk auquel est connectée cette interface de communication IC de l'organe Oj.

On notera que dans l'exemple illustré non limitativement sur l'unique figure, un dispositif de test DT est associé en interne à chaque interface de communication IC de chaque organe Oj. Mais cela n'est pas obligatoire. En effet, l'un au moins des organes Oj d'un réseau RC peut être équipé d'un dispositif de test DT, et lorsqu'un organe Oj comprend plusieurs interfaces de communication IC, l'une au moins de ces dernières (IC) peut être associée à un dispositif de test DT.

On notera également que dans l'exemple illustré non limitativement sur l'unique figure, chaque dispositif de test DT est connecté non seulement à une interface de communication IC de l'organe Oj dont il fait partie, mais également à un médium de communication MCk auquel est connectée cette interface de communication IC de l'organe Oj. Mais cela n'est pas obligatoire. En effet, l'un au moins des dispositifs de test DT peut être connecté seulement à une interface de communication IC de l'organe Oj dont il fait partie, ou bien seulement à un médium de communication MCk qui est connecté à une interface de communication IC de l'organe Oj dont il fait partie.

Les moyens de génération MG d'un premier organe Oj sont agencés pour générer un test qui est destiné à être transmis à une interface de communication IC de ce premier organe Oj ou par un premier médium de communication MCk auquel est connecté ce premier organe Oj. On comprendra que le mode de transmission dépend de la connexion du dispositif de test DT considéré à une interface de communication IC et/ou à un médium de communication MCk.

Chaque test généré est destiné à provoquer une réaction à ce test d'une partie au moins de l'interface de communication IC du premier organe Oj et d'au moins le premier médium de communication MCk auquel est connecté ce premier organe Oj, et/ou d'une partie au moins de l'interface de communication IC d'un second organe Oj' (j' ≠ j) du réseau RC. Par exemple, en présence d'un défaut consistant en une coupure du médium de communication, l'interface de communication IC du second organe Oj' (j' ≠ j) du réseau RC n'est pas accessible par le signal de test, ce que certaines variantes du dispositif DC selon l'invention peuvent détecter.

En d'autres termes, un test généré par un dispositif de test DT d'un premier organe Oj peut être notamment destiné à provoquer la réaction :
- d'une partie au moins de l'interface de communication IC du premier organe Oj, du premier médium de communication MCk auquel est connecté ce premier organe Oj, et d'une partie au moins de l'interface de communication IC d'un second organe Oj' du réseau RC, ou
- d'une partie au moins de l'interface de communication IC du premier organe Oj, du premier médium de communication MCk auquel est connecté ce premier organe Oj, d'une partie au moins de l'interface de communication IC d'un second organe Oj' du réseau RC, ainsi qu'éventuellement d'un second médium de communication MCk' auquel est connecté ce second organe Oj', ou
- d'une partie au moins de l'interface de communication IC d'un second organe Oj' du réseau RC, ainsi qu'éventuellement d'un second médium de communication MCk' auquel est connecté ce second organe Oj'.

Grâce aux tests qui sont générés par le(s) dispositif(s) de test DT, il est désormais possible de tester certains au moins des canaux de communication de la couche physique du réseau RC, que ce soit dans une phase de conception ou de mise au point de ce dernier (RC), ou bien une fois que ce dernier (RC) a été entièrement installé dans un système, comme par exemple un véhicule. Par conséquent, le test d'un réseau RC peut se faire aussi bien dans un laboratoire (par exemple d'une usine), que dans un service après-vente, ou qu'en n'importe quel endroit (par exemple dans le cadre d'une analyse consécutive à un défaut ou une panne).

Il est rappelé que l'on entend ici par « canal de communication » un ensemble d'éléments physiques assurant la transmission filaire entre des premier et second organes, ces éléments étant une partie au moins de l'interface de communication du premier organe, au moins un médium de communication filaire, et/ou une partie au moins de l'interface de communication du second organe.

Par exemple, les moyens de génération MG d'un dispositif de test DT d'un premier organe Oj peuvent être agencés pour générer un fichier de paramétrage qui définit un test et qui est propre à provoquer un nouveau paramétrage d'une interface de communication IC de ce premier organe Oj ou d'une interface de communication IC d'un second organe Oj' du réseau RC. On comprendra que l'utilisation d'une interface de communication IC re-paramétrée par un fichier de paramétrage va provoquer une nouvelle réaction qui va alors pouvoir être observée et donc analysée.

Egalement par exemple, les moyens de génération MG d'un dispositif de test DT d'un premier organe Oj peuvent être agencés pour générer une forme d'onde (par exemple en tension) qui définit un test et qui est propre à être transmise par un premier médium de communication MCk auquel est connecté ce premier organe Oj. On comprendra que l'utilisation d'un premier médium de communication MCk pour transmettre une forme d'onde va provoquer une réaction, comme par exemple une modification de cette dernière, qui va alors pouvoir être observée et donc analysée.

Les moyens de génération MG peuvent être réalisés sous la forme de circuits électroniques (ou « hardware »), ou bien d'une combinaison de circuits électroniques et de modules logiciels (ou informatiques ou encore « software »), par exemple de traitement numérique du signal.

On notera, comme illustré non limitativement, qu'un dispositif de test DT d'un premier organe Oj peut également et avantageusement comprendre des moyens de détermination MD agencés pour déterminer la réaction provoquée par un test, via un premier médium de communication MCk de ce premier organe Oj et/ou une interface de communication IC de ce premier organe Oj.

Pour ce faire, les moyens de détermination MD d'un dispositif de test DT d'un organe Oj peuvent, par exemple, être agencés pour déterminer une variation d'une forme d'onde de test qui résulte de la transmission de cette dernière depuis des moyens de génération MG. Cette variation constitue alors la réaction au test généré.

Il est important de noter qu'en présence de dispositifs de test DT dans plusieurs organes Oj, il est possible de générer un test avec un dispositif de test DT d'un premier organe Oj et de déterminer la réaction provoquée par ce test avec les moyens de détermination MD d'un dispositif de test DT de l'un au moins des autres organes Oj' (j' ≠ j). Mais il est également possible de générer un test avec un dispositif de test DT d'un premier organe Oj et de déterminer la réaction provoquée par ce test avec les moyens de détermination MD de ce même dispositif de test DT.

Les moyens de détermination MD peuvent être réalisés sous la forme de circuits électroniques, ou bien d'une combinaison de circuits électroniques et de modules logiciels, par exemple de traitement numérique du signal.

On notera également, comme illustré non limitativement, qu'un dispositif de test DT peut également comprendre des moyens d'enregistrement ME agencés pour enregistrer une réaction déterminée consécutivement à la génération d'un test, par exemple en correspondance d'un identifiant de ce test. Cette option est notamment destinée à permettre la récupération d'une réaction enregistrée dans des moyens d'enregistrement ME en vue de leur analyse, comme on le verra plus loin.

Ces moyens d'enregistrement ME peuvent, par exemple, être agencés sous la forme d'une mémoire, éventuellement de type logiciel, par exemple avec comptage d'événements.

On notera également, comme illustré non limitativement, qu'un dispositif de test DT peut également comprendre une ligne de diagnostic LD qui est propre à être couplée à un équipement de communication EC externe afin de transmettre aux moyens de génération MG une commande requérant la génération d'un test choisi ou une définition d'un test à générer fournie par cet équipement de communication EC et/ou de recevoir des résultats de test(s).

Cet équipement de communication EC comprend une interface homme/machine et un écran d'affichage EA. Il peut, par exemple, s'agir d'un ordinateur fixe ou portable, ou d'une tablette communicante, ou encore d'un équipement dédié au diagnostic.

Par exemple, l'usager de l'équipement de communication EC peut choisir dans une liste stockée un test concernant au moins un élément à tester de la couche physique du réseau RC et déclencher la transmission d'une commande désignant ce test choisi au(x) dispositif(s) de test DT du réseau RC qui est (sont) chargés de générer ce test choisi et/ou de déterminer la réaction à ce test choisi. En variante, l'usager de l'équipement de communication EC peut choisir dans une liste stockée ou définir lui-même une définition d'un test à générer concernant au moins un élément à tester de la couche physique du réseau RC et déclencher la transmission de cette définition de test au(x) dispositif(s) de test DT du réseau RC qui est (sont) chargés de générer ce test ou de déterminer la réaction à ce test.

Lorsque le dispositif de test DT comprend également des moyens de détermination MD et/ou des moyens d'enregistrement ME, son éventuelle ligne de diagnostic LD peut également permettre à un usager de l'équipement de communication EC de récupérer avec ce dernier (EC) une réaction déterminée suite à la réalisation d'un test, et éventuellement enregistrée (ou stockée), en vue de son analyse sur l'écran EA.

On comprendra que le stockage de la réaction, permet en effet à l'usager d'analyser cette dernière quand il le désire, et même si celle-ci a une durée trop courte pour que l'usager puisse l'analyser en temps réel.

On notera également que dans l'exemple illustré non limitativement sur l'unique figure, chaque dispositif de test DT comprend une ligne de diagnostic LD. Mais cela n'est pas obligatoire. En effet, l'un au moins des dispositifs de test DT peut ne pas comprendre de ligne de diagnostic LD. Dans ce cas, chaque organe Oj peut comporter un dispositif de déclenchement de test(s), par exemple avec des boutons ou des entrées dédiés, et un dispositif d'analyse, par exemple avec des voyants ou des sorties dédiés. Dans une variante, chaque organe Oj peut être agencé pour déclencher un ou plusieurs tests dans certaines phases particulières, comme par exemple après la mise sous tension du véhicule.

On notera également que dans l'exemple illustré non limitativement sur l'unique figure, toutes les lignes de diagnostic LD sont connectées à une ligne principale de diagnostic LPD qui peut être connectée à l'équipement de communication EC, via un câble. Cela est particulièrement avantageux, car cela évite d'avoir à connecter l'équipement de communication EC à chaque organe Oj ayant un dispositif de test DT devant intervenir dans un test (pour la génération et/ou la détermination de réaction). Par exemple, dans le cas d'un véhicule, cette ligne principale de diagnostic LPD peut comprendre une extrémité au niveau d'une prise de diagnostic, réglementaire ou non.

On notera également que les tests peuvent être effectués dans un mode de fonctionnement spécifique du réseau RC dit « mode de test » pendant lequel la communication fonctionnelle entre les organes Oj est interrompue ou partielle, par exemple en mono-directionnel. Cette situation peut notamment survenir pendant les phases de mise au point ou lors de chaque démarrage ou redémarrage du réseau RC.

Mais on peut également envisager de déclencher le mode de test pendant d'autres phases, et par exemple lorsque l'on réalise des mesures de compatibilité électromagnétique du véhicule complet. Un tel déclenchement peut par exemple se faire via une ligne de diagnostic LD ou au moyen d'un message fonctionnel transmis via le réseau RC à chaque organe Oj concerné.

On notera également que le résultat de chaque test (réaction(s) déterminée(s)) peut, éventuellement, être utilisé de façon automatique en interne, par exemple pour améliorer de façon automatisée le paramétrage d'une interface de communication IC.

Par ailleurs, des traitements des données brutes des résultats des tests (réactions déterminées) peuvent, éventuellement, être effectués par l'un au moins des organes Oj du réseau RC. Ces traitements peuvent, par exemple, être de type statistique ou relatifs à la datation (marquage temporel).

L'invention permet avantageusement de tester la couche physique des réseaux de communication filaires, à haut débit et à communication bidirectionnelle sur un même médium, de façon précise. Elle s'avère donc particulièrement utile dans les phases de développement (ou conception), de mise au point et de réparation (notamment des véhicules). Cela peut induire une amélioration notable de la sûreté de fonctionnement des réseaux de communication filaires, en particulier lors d'usages critiques (comme par exemple dans le cas de véhicules autonomes).

## Revendications

1. Réseau de communication (RC) de type filaire, à haut débit et à communication bidirectionnelle sur un même médium, **caractérisé en ce qu'**il comprend au moins un premier organe (Oj) et un deuxième organes (Oj'), couplés entre eux via au moins un médium de communication (MCk), lesdits premier (Oj) et deuxième (Oj') organes comprenant chacun au moins une interface de communication (IC) connectée au premier médium de communication (MCk) et au moins un dispositif de test (DT) connecté à ladite interface de communication (IC) dudit organe (Oj) et/ou audit premier médium de communication (MCk), ledit dispositif de test (DT) du premier organe (Oj) comprenant des moyens de génération (MG) propres à être connectés à ladite interface de communication (IC) et/ou audit premier médium de communication (MCk), et agencés pour générer un test destiné à être transmis à ladite interface de communication (IC) du premier organe (Oj) ou par ledit premier médium de communication (MCk) pour provoquer une réaction audit test d'une partie au moins de ladite interface de communication (IC) du premier organe (Oj) et d'au moins ledit premier médium de communication (MCk), et/ou d'une partie au moins de ladite interface de communication (IC) dudit second organe (Oj').

2. Réseau de communication (RC) selon la revendication 1, **caractérisé en ce que** lesdits moyens de génération (MG) sont agencés pour générer un fichier de paramétrage définissant ledit test et propre à provoquer un nouveau paramétrage de ladite interface de communication (IC) du premier organe (Oj) et/ou de ladite interface de communication (IC) du second organe (Oj').

3. Réseau de communication (RC) selon l'une des revendications 1 et 2, **caractérisé en ce que** lesdits moyens de génération (MG) sont agencés pour générer une forme d'onde définissant ledit test et propre à être transmise par ledit premier médium de communication (MCk).

4. Réseau de communication (RC) selon l'une des revendications 1 à 3, **caractérisé en ce qu'**il comprend des moyens de détermination (MD) agencés pour déterminer ladite réaction provoquée par ledit test, via ledit premier médium de communication (MCk) et/ou ladite interface de communication (IC) du premier organe (Oj).

5. Réseau de communication (RC) selon la combinaison des revendications 3 et 4, **caractérisé en ce que** lesdits moyens de détermination (MD) sont agencés pour déterminer une variation de ladite forme d'onde résultant de la transmission de cette dernière depuis lesdits moyens de génération (MG), cette variation constituant ladite réaction.

6. Réseau de communication (RC) selon l'une des revendications 4 et 5, **caractérisé en ce qu'**il comprend des moyens d'enregistrement (ME) agencés pour enregistrer ladite réaction déterminée en correspondance d'un identifiant dudit test.

7. Réseau de communication (RC) selon l'une des revendications 1 à 6, **caractérisé en ce qu'**il comprend une ligne de diagnostic (LD) propre à être couplée à un équipement de communication (EC) externe afin de transmettre auxdits moyens de génération (MG) une commande requérant la génération d'un test choisi ou une définition d'un test à générer et/ou de recevoir des résultats de test(s).

8. Véhicule, **caractérisé en ce qu'**il comprend au moins un réseau de communication (RC) selon l'une des revendications précédentes.

## Patentansprüche

1. Kommunikationsnetzwerk (RC) vom verdrahteten Typ, mit Hochgeschwindigkeits- und bidirektionaler Kommunikation auf einem selben Medium, **dadurch gekennzeichnet, dass** es mindestens ein erstes Organ (Oj) und ein zweites Organ (Oj') umfasst, die miteinander über mindestens ein Kommunikationsmedium (MCk) gekoppelt sind, wobei das erste (Oj) und das zweite Organ (Oj') jeweils mindestens eine Kommunikationsschnittstelle (IC) umfassen, die mit dem ersten Kommunikationsmedium (MCk) verbunden ist, und mindestens eine Testvorrichtung (DT), die mit der Kommunikationsschnittstelle (IC) des Organs (Oj) und/oder mit dem ersten Kommunikationsmedium (MCk) verbunden ist, wobei die Testvorrichtung (DT) des ersten Organs (Oj) Mittel zum Erzeugen (MG) umfasst, die dazu geeignet sind, mit der Kommunikationsschnittstelle (IC) und/oder mit dem ersten Kommunikationsmedium (MCk) verbunden zu sein, und die eingerichtet sind, um einen Test zu erzeugen, der dazu bestimmt ist, zu der Kommunikationsschnittstelle (IC) des ersten Organs (Oj) oder durch das erste Kommunikationsmedium (MCk) übertragen zu werden, um eine Reaktion auf den Test mindestens eines Teils der Kommunikationsschnittstelle (IC) des ersten Organs (Oj) und mindestens des ersten Kommunikationsmediums (MCk) und/oder eines Teils mindestens der Kommunikationsschnittstelle (IC) des zweiten Organs (Oj') hervorzurufen.

2. Kommunikationsnetzwerk (RC) nach Anspruch 1, **dadurch gekennzeichnet, dass** die Erzeugungsmittel (MG) eingerichtet sind, um eine Parametrierungsdatei zu erzeugen, die den Test definiert, und geeignet ist, um eine neue Parametrierung der Kommunikationsschnittstelle (IC) des ersten Organs (Oj) und/oder der Kommunikationsschnittstelle (IC) des zweiten Organs (Oj') hervorzurufen.

3. Kommunikationsnetzwerk (RC) nach einem der Ansprüche 1 und 2, **dadurch gekennzeichnet, dass** die Erzeugungsmittel (MG) eingerichtet sind, um eine Wellenform zu erzeugen, die den Test definiert, und die dazu geeignet ist, von dem ersten Kommunikationsmedium (MCk) übertragen zu werden.

4. Kommunikationsnetzwerk (RC) nach einem der Ansprüche 1 bis 3, **dadurch gekennzeichnet, dass** es Bestimmungsmittel (MD) umfasst, die eingerichtet sind, um die Reaktion, die von dem Test hervorgerufen wird, über das erste Kommunikationsmedium (MCk) und/oder über die Kommunikationsschnittstelle (IC) des ersten Organs (Oj) zu bestimmen.

5. Kommunikationsnetzwerk (RC) nach der Kombination der Ansprüche 3 und 4, **dadurch gekennzeichnet, dass** die Bestimmungsmittel (MD) eingerichtet sind, um eine Variation der Wellenform zu bestimmen, die aus der Übertragung dieser Letzteren von den Erzeugungsmitteln (MG) resultiert, wobei diese Variation die Reaktion bildet.

6. Kommunikationsnetzwerk (RC) nach einem der Ansprüche 4 und 5, **dadurch gekennzeichnet, dass** es Aufzeichnungsmittel (ME) umfasst, die eingerichtet sind, um die bestimmte Reaktion in Entsprechung mit einem Identifikator des Tests aufzuzeichnen.

7. Kommunikationsnetzwerk (RC) nach einem der Ansprüche 1 bis 6, **dadurch gekennzeichnet, dass** es eine Diagnoseleitung (LD) umfasst, die geeignet ist, mit einer externen Kommunikationsausstattung (EC) gekoppelt zu sein, um den Erzeugungsmitteln (MG) einen Befehl zu übertragen, der das Erzeugen eines ausgewählten Tests oder einer Definition eines zu erzeugenden Tests und/oder das Empfangen der Resultate eines Tests (von Tests) anfordert.

8. Fahrzeug, **dadurch gekennzeichnet, dass** es mindestens ein Kommunikationsnetzwerk (RC) nach einem der vorstehenden Ansprüche umfasst.

## Claims

1. A communication network (RC) of the wired type, with high speed and with birectional communication on a single medium, **characterized in that** it includes at least a first member (Oj) and a second member (Oj'), coupled with one another via at least one communication medium (MCk), said first (Oj) and second (Oj') members each including at least one communication interface (IC) connected to the first communication medium (MCk) and at least one testing device (DT) connected to said communication interface (IC) of said member (Oj) and/or to said first communication medium (MCk), said testing device (DT) of the first member (Oj) including generation means (MG) suitable to be connected to said communication interface (IC) and/or to said first communication medium (MCk), and arranged to generate a test intended to be transmitted to said communication interface (IC) of the first member (Oj) or by said first communication medium (MCk) to cause a reaction to said test of a portion at least of said communication interface (IC) of the first member (Oj) and of at least said first communication medium (MCk), and/or of a portion at least of said communication interface (IC) of said second member (Oj').

2. The communication network (RC) according to Claim 1, **characterized in that** said generation means (MG) are arranged to generate a setting file defining said test and suitable to cause a new setting of said communication interface (IC) of the first member (Oj) and/or of said communication interface (IC) of the second member (Oj').

3. The communication network (RC) according to one of Claims 1 and 2, **characterized in that** said generation means (MG) are arranged to generate a waveform defining said test and suitable to be transmitted by said first communication medium (MCk).

4. The communication network (RC) according to one of Claims 1 to 3, **characterized in that** it includes determination means (MD) arranged to determine said reaction caused by said test, via said first communication medium (MCk) and/or said communication interface (IC) of the first member (Oj).

5. The communication network (RC) according to the combination of Claims 3 and 4, **characterized in that** said determination means (MD) are arranged to determine a variation of said waveform resulting from the transmission of the latter from said generation means (MG), this variation constituting said reaction.

6. The communication network (RC) according to one of Claims 4 and 5, **characterized in that** it includes recording means (ME) arranged for recording said determined reaction matching an identifier of said test.

7. The communication network (RC) according to one of Claims 1 to 6, **characterized in that** it includes a diagnostic line (LD) suitable to be coupled to an external communication equipment (EC) so as to transmit to said generation means (MG) a command requiring the generation of a selected test or a definition of a test to be generated and/or to receive results of test(s).

8. A vehicle, **characterized in that** it includes at least one communication network (RC) according to one of the preceding claims.
